# EUROPEAN PATENT APPLICATION

(11) **EP 4 435 868 A1**
(43) Date of publication of application: **25.09.2024**
(21) Application number: 23191687.5
(22) Date of filing: 16.08.2023
(51) Int. Cl.: H01L 29/12, H01L 29/78, H01L 29/06, H01L 21/336

(54) **SEMICONDUCTOR DEVICE AND METHOD FOR MANUFACTURING THE SAME**

(30) Priority: 24.03.2023 JP 2023049093
(71) Applicant: Kabushiki Kaisha Toshiba, Tokyo 105-0023 (JP); Toshiba Electronic Devices & Storage Corporation, Tokyo 105-0023 (JP)
(72) Inventor: KIYOSAWA, Tsutomu, Minato-ku (JP)
(74) Representative: Kramer Barske Schmidtchen Patentanwälte PartG mbB

(57) **Abstract**

A semiconductor device according to embodiments includes a device region and a dicing region surrounding the device region. The device region includes a first electrode, a second electrode, and a silicon carbide layer having a first face on the side of the first electrode and a second face on the side of the second electrode. At least a portion of the silicon carbide layer is provided between the first electrode and the second electrode. The dicing region includes the silicon carbide layer having the first face and the second face. A first maximum distance from the second face to the first face of the device region in a normal direction of the second face is greater than a second maximum distance from the second face to the first face of the dicing region in the normal direction.

## Description

### CROSS-REFERENCE TO RELATED APPLICATION

This application is based upon and claims the benefit of priority from Japanese Patent Application No. 2023-049093, filed on March 24, 2023, the entire contents of which are incorporated herein by reference.

### FIELD

Embodiments described herein relate generally to a semiconductor device and a method for manufacturing the semiconductor device.

### BACKGROUND

Silicon carbide (SiC) is used as a material for a semiconductor device. Silicon carbide has excellent physical properties such as a band gap about 3 times wider, a breakdown field strength about 10 times higher, and a thermal conductivity about 3 times higher than those of silicon. These properties make it possible to realize, for example, a high-breakdown-voltage, low-loss, and hightemperature-operable metal-oxide semiconductor field-effect transistor (MOSFET).

For example, when MOSFETs using silicon carbide is manufactured, a plurality of MOSFETs formed on a silicon carbide wafer is separated by cutting the wafer along a dicing region provided around a device region. When the wafer is cut along the dicing region, there is a possibility that the device region may be cracked, which causes a decrease in the reliability of the MOSFETs. Specifically, for example, there is a possibility that moisture and mobile ions may enter the device region through a crack, which causes degradation of device characteristics or short circuit failure of the MOSFETs.

### BRIEF DESCRIPTION OF THE DRAWINGS

FIG. 1 is a schematic diagram of a semiconductor device according to a first embodiment;
FIG. 2 is a schematic diagram of the semiconductor device according to the first embodiment;
FIG. 3 is a diagram that describes a method for manufacturing the semiconductor device according to the first embodiment;
FIG. 4 is a diagram that describes the method for manufacturing the semiconductor device according to the first embodiment;
FIG. 5 is a diagram that describes the method for manufacturing the semiconductor device according to the first embodiment;
FIG. 6 is a diagram that describes the method for manufacturing the semiconductor device according to the first embodiment;
FIG. 7 is a diagram that describes the method for manufacturing the semiconductor device according to the first embodiment;
FIG. 8 is a diagram that describes the method for manufacturing the semiconductor device according to the first embodiment;
FIG. 9 is a diagram that describes the method for manufacturing the semiconductor device according to the first embodiment;
FIG. 10 is a diagram that describes the method for manufacturing the semiconductor device according to the first embodiment;
FIG. 11 is a diagram that describes the method for manufacturing the semiconductor device according to the first embodiment;
FIG. 12 is a diagram that describes the method for manufacturing the semiconductor device according to the first embodiment;
FIG. 13 is a diagram that describes the method for manufacturing the semiconductor device according to the first embodiment;
FIG. 14 is a diagram that describes the method for manufacturing the semiconductor device according to the first embodiment;
FIG. 15 is a schematic cross-sectional view of a semiconductor device according to a comparative example;
FIG. 16 is a diagram that describes a problem of the semiconductor device and its manufacturing method according to the comparative example;
FIG. 17 is a diagram that describes the function and effect of the semiconductor device and its manufacturing method according to the first embodiment;
FIG. 18 is a schematic diagram of a semiconductor device according to a modification example of the first embodiment;
FIG. 19 is a schematic diagram of the semiconductor device according to the modification example of the first embodiment;
FIG. 20 is a diagram that describes the function and effect of the semiconductor device and its manufacturing method according to the modification example of the first embodiment;
FIG. 21 is a schematic diagram of a semiconductor device according to a second embodiment;
FIG. 22 is a diagram that describes the function and effect of the semiconductor device and its manufacturing method according to the second embodiment;
FIG. 23 is a schematic diagram of a semiconductor device according to a third embodiment;
FIG. 24 is a diagram that describes a method for manufacturing the semiconductor device according to the third embodiment;
FIG. 25 is a diagram that describes the method for manufacturing the semiconductor device according to the third embodiment; and
FIG. 26 is a diagram that describes the method for manufacturing the semiconductor device according to the third embodiment.

### DETAILED DESCRIPTION

A semiconductor device according to embodiments including: a device region; and a dicing region surrounding the device region, the device region including a first electrode, a second electrode, and a silicon carbide layer having a first face on the side of the first electrode and a second face on the side of the second electrode, at least a portion of the silicon carbide layer provided between the first electrode and the second electrode, the dicing region including the silicon carbide layer having the first face and the second face, in which a first maximum distance from the second face to the first face of the device region in a normal direction of the second face is greater than a second maximum distance from the second face to the first face of the dicing region in the normal direction.

Embodiments of the present disclosure will be described below with reference to the drawings. It is noted that in the following description, the same or similar members or somethings are assigned the same reference numeral, and description of the member or something that once has been described may be omitted accordingly.

Furthermore, in the following description, the notations "n⁺, n, n⁻" and "p⁺, p, p⁻" represent the relative levels of impurity concentration in respective conductive types. That is, n⁺ indicates a relatively higher n-type impurity concentration than n, and n⁻ indicates a relatively lower n-type impurity concentration than n. Furthermore, p⁺ indicates a relatively higher p-type impurity concentration than p, and p⁻ indicates a relatively lower p-type impurity concentration than p. It is noted that an n⁺-type and an n⁻-type may be simply referred to as an n-type; and a p⁺-type and a p⁻-type may be simply referred to as a p-type.

The impurity concentration can be measured by, for example, secondary ion mass spectrometry (SIMS). Furthermore, the relative level of the impurity concentration can be determined by, for example, the level of carrier concentration found by means of scanning capacitance microscopy (SCM). The distance, such as the width or the depth, of an impurity region can be found by means of, for example, SIMS. Furthermore, the distance, such as the width or the depth, of an impurity region can be found from, for example, an SCM image or a scanning electron microscope (SEM) image.

Respective thicknesses of substances constituting the semiconductor device and the distance between the substances can be measured on, for example, a SIMS image, a SEM image, or a transmission electron microscope (TEM) image.

It is noted that in the present specification, the "p-type impurity concentration" of a p-type silicon carbide region means the net p-type impurity concentration obtained by subtracting the n-type impurity concentration of the region from the p-type impurity concentration of the region. Furthermore, the "n-type impurity concentration" of an n-type silicon carbide region means the net n-type impurity concentration obtained by subtracting the p-type impurity concentration of the region from the n-type impurity concentration of the region.

Moreover, unless otherwise stated in the specification, the impurity concentration of a specific region means the maximum impurity concentration of the region.

### (First Embodiment)

A semiconductor device according to a first embodiment includes a device region and a dicing region surrounding the device region. The device region includes: a first electrode; a second electrode; and a silicon carbide layer having a first face on the side of the first electrode and a second face on the side of the second electrode, at least a portion of the silicon carbide layer being provided between the first electrode and the second electrode. The dicing region includes the silicon carbide layer having the first face and the second face. A first maximum distance from the second face to the first face of the device region in a normal direction of the second face is greater than a second maximum distance from the second face to the first face of the dicing region in the normal direction.

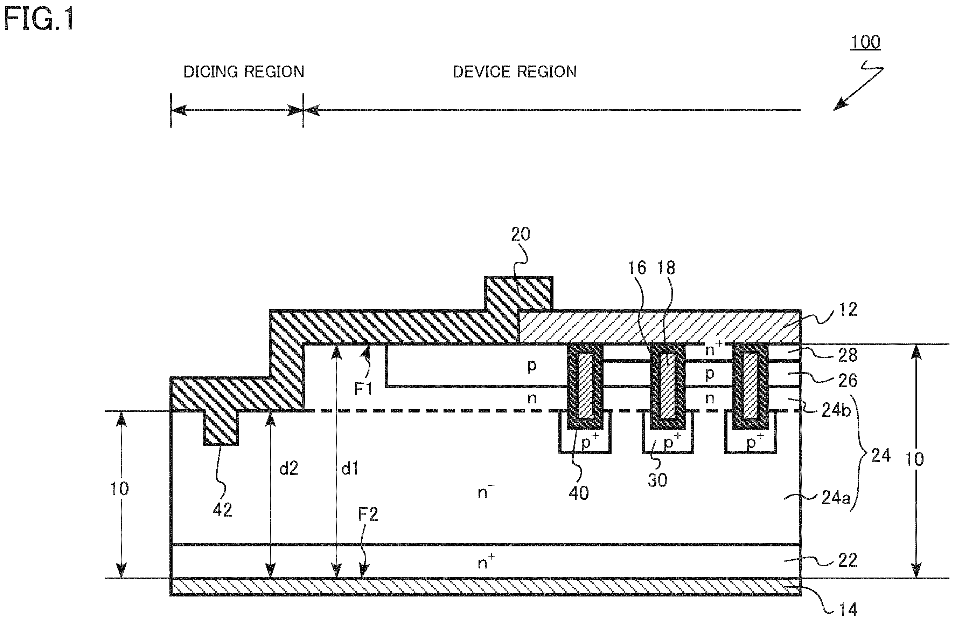

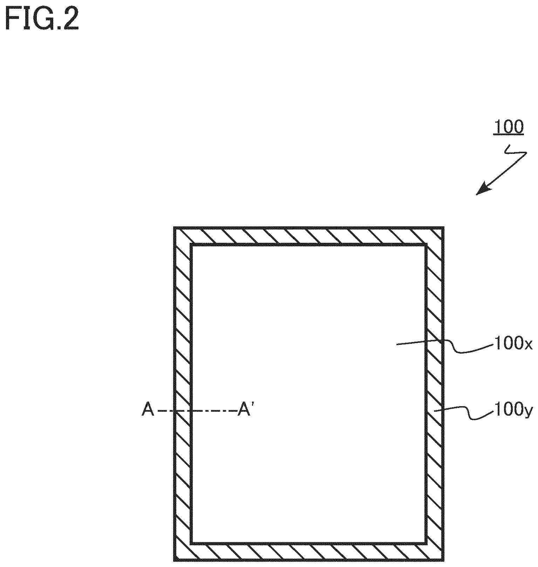

FIGS. 1 and 2 are schematic diagrams of a semiconductor device according to the first embodiment. FIG. 1 is a schematic cross-sectional view of part of the semiconductor device according to the first embodiment. FIG. 2 is a top view of the semiconductor device according to the first embodiment. FIG. 1 is a cross-sectional view of the semiconductor device along the line A-A' shown in FIG. 2.

The semiconductor device according to the first embodiment is a vertical MOSFET 100 using silicon carbide. The MOSFET 100 is a trench gate type MOSFET with a gate electrode formed in a trench.

Below, a case where a first conductive type is the n-type, and a second conductive type is the p-type is described as an example. The MOSFET 100 is an n-channel MOSFET using electrons as carriers.

The MOSFET 100 includes a device region 100x and a dicing region 100y. The dicing region 100y surrounds the device region 100x.

In the device region 100x, for example, a transistor is provided. The dicing region 100y is a region provided for dividing a plurality of MOSFETs 100 formed on a silicon carbide substrate by dicing. The dicing region 100y is a so-called dicing line or scribe line.

The MOSFET 100 includes a silicon carbide layer 10, a source electrode 12, a drain electrode 14, a gate insulating layer 16, a gate electrode 18, and a protective insulating layer 20. The source electrode 12 is an example of the first electrode. The drain electrode 14 is an example of the second electrode. The protective insulating layer 20 is an example of an insulating layer.

At least a portion of the silicon carbide layer 10 is provided between the source electrode 12 and the drain electrode 14. The silicon carbide layer 10 is singlecrystal SiC. The silicon carbide layer 10 is, for example, 4H-SiC. The thickness of the silicon carbide layer 10 is, for example, equal to or more than 5 um and equal to or less than 150 µm.

The silicon carbide layer 10 has a first face ("F1" in FIG. 1) and a second face ("F2" in FIG. 1). Hereinafter, the first face may be referred to as the surface, and the second face may be referred to as the back surface. It is noted that hereinafter, the "depth" means the depth based on the first face.

The first face F1 is a face of the silicon carbide layer 10 on the side of the source electrode 12. The second face F2 is a face of the silicon carbide layer 10 on the side of the drain electrode 14.

The first face F1 is, for example, a face inclined at an angle of equal to or more than 0 degrees and equal to or less than 8 degrees with respect to a (0001) face. Furthermore, the second face F2 is, for example, a face inclined at an angle of equal to or more than 0 degrees and equal to or less than 8 degrees with respect to a (000-1) face. The (0001) face is referred to as a silicon face. The (000-1) face is referred to as a carbon face.

The device region 100x includes the silicon carbide layer 10, the source electrode 12, the drain electrode 14, the gate insulating layer 16, the gate electrode 18, and the protective insulating layer 20.

In the silicon carbide layer 10 of the device region 100x, an n⁺-type drain region 22, an n-type drift region 24, a p-type body region 26, an n⁺-type source region 28, and a p⁺-type electric field relaxation region 30 are provided.

The drift region 24 includes an n⁻-type lower region 24a and an n-type upper region 24b. The lower region 24a is an example of a first silicon carbide region. The upper region 24b is an example of a second silicon carbide region.

Furthermore, the silicon carbide layer 10 of the device region 100x includes a trench 40.

The n⁺-type drain region 22 is provided on the side of the back surface of the silicon carbide layer 10.

The n-type drift region 24 is provided between the drain region 22 and the first face F1. The drift region 24 is provided on the drain region 22.

The n-type upper region 24b is provided between the n⁻-type lower region 24a and the first face F1. The n-type upper region 24b is provided on the n⁻-type lower region 24a.

The lower region 24a is, for example, an epitaxial growth layer formed on the drain region 22 by an epitaxial growth method. Furthermore, for example, the upper region 24b is an epitaxial growth layer formed on the lower region 24a by the epitaxial growth method.

The drift region 24 contains, for example, nitrogen (N) as an n-type impurity. The n-type impurity concentration of the drift region 24 is lower than the n-type impurity concentration of the drain region 22.

The n-type impurity concentration of the upper region 24b is, for example, different from the n-type impurity concentration of the lower region 24a. The n-type impurity concentration of the upper region 24b is, for example, higher than the n-type impurity concentration of the lower region 24a.

It is noted that the n-type impurity concentration of the upper region 24b can be, for example, lower than the n-type impurity concentration of the lower region 24a. Furthermore, the n-type impurity concentration of the upper region 24b can be equal to the n-type impurity concentration of the lower region 24a.

The p-type body region 26 is provided between the drift region 24 and the first face F1. The body region 26 functions as a channel region of the MOSFET 100. The body region 26 contains, for example, aluminum (Al) as a p-type impurity.

The n⁺-type source region 28 is provided between the body region 26 and the first face F1. The source region 28 contains, for example, phosphorus (P) as an n-type impurity. The n-type impurity concentration of the source region 28 is higher than the n-type impurity concentration of the drift region 24.

The p⁺-type electric field relaxation region 30 is provided between the drift region 24 and the trench 40. The electric field relaxation region 30 has a function of relaxing an electric field applied to the gate insulating layer 16 on the bottom of the trench 40.

The electric field relaxation region 30 contains, for example, aluminum (Al) as a p-type impurity. The p-type impurity concentration of the electric field relaxation region 30 is higher than the p-type impurity concentration of the body region 26.

The trench 40 is provided on the side of the first face F1 of the silicon carbide layer 10. The trench 40 is a recess provided in the silicon carbide layer 10. The depth of the trench 40 is, for example, equal to or more than 1 um and equal to or less than 3 µm.

The gate electrode 18 is provided in the trench 40. The gate insulating layer 16 is provided between the gate electrode 18 and the silicon carbide layer 10.

The source electrode 12 is provided on the side of the first face F1 of the silicon carbide layer 10. The source electrode 12 is in contact with the source region 28.

The drain electrode 14 is provided on the side of the second face F2 of the silicon carbide layer 10. The drain electrode 14 is in contact with the drain region 22.

The protective insulating layer 20 is provided on the source electrode 12. The protective insulating layer 20 is an example of an insulating layer. The protective insulating layer 20 has a function of protecting the device region from, for example, mechanical stress and moisture.

The protective insulating layer 20 is, for example, an oxide, a nitride, or a resin. The protective insulating layer 20 is, for example, a silicon oxide, a silicon nitride, or a polyimide resin.

The outermost surface of the device region 100x on the side of the first face F1 is, for example, the source electrode 12 or the protective insulating layer 20.

The dicing region 100y includes the silicon carbide layer 10, the drain electrode 14, and the protective insulating layer 20.

It is noted that an interlayer insulating film including silicon oxide, etc. may be provided between the source electrode 12 and the outermost surface of the first face F1, for example, between the source electrode 12 and the gate electrode 18. Furthermore, the interlayer insulating film may be provided to extend from the first face F1 of the device region 100x to the first face F1 of the dicing region 100y. In that case, a portion of the protective insulating layer 20 is disposed on at least a portion of the interlayer insulating film.

In the silicon carbide layer 10 of the dicing region 100y, the n⁺-type drain region 22 and the n-type drift region 24 are provided.

The drift region 24 includes the n⁻-type lower region 24a. The lower region 24a is an example of a first silicon carbide region.

The lower region 24a is in contact with the first face F1 of the silicon carbide layer 10 of the dicing region 100y.

Furthermore, the silicon carbide layer 10 of the dicing region 100y includes, for example, an alignment mark 42. The alignment mark 42 functions as an alignment mark between patterns in a photolithography step when the MOSFET 100 is manufactured.

The alignment mark 42 is a recess or a protrusion provided on the surface of the silicon carbide layer 10.

FIG. 1 illustrates a case where the alignment mark 42 is a recess. The depth of the alignment mark 42 is, for example, equal to or more than 0.5 um and equal to or less than 3 µm.

A first maximum distance (d1 in FIG. 1) from the second face F2 to the first face F1 of the device region 100x in the normal direction of the second face F2 is greater than a second maximum distance (d2 in FIG. 1) from the second face F2 to the first face F1 of the dicing region 100y in the normal direction of the second face F2. A difference between the first maximum distance d1 and the second maximum distance d2 is, for example, equal to or more than 0.5 um and equal to or less than 3 µm.

There is a step or a difference in level on the surface of the silicon carbide layer 10 between the device region 100x and the dicing region 100y. There is a step or a difference in level on the first face F1 of the silicon carbide layer 10 between the device region 100x and the dicing region 100y. The step height between the device region 100x and the dicing region 100y is, for example, equal to or more than 0.5 um and equal to or less than 3 µm.

Subsequently, an example of a method for manufacturing the semiconductor device according to the first embodiment is described. As an example, the method for manufacturing the semiconductor device according to the first embodiment includes: forming a mask material on a silicon carbide substrate having an expected device region and an expected dicing region surrounding the expected device region and including a first silicon carbide layer; removing the mask material of the expected device region; and forming a second silicon carbide layer on the first silicon carbide layer of the expected device region by the epitaxial growth method.

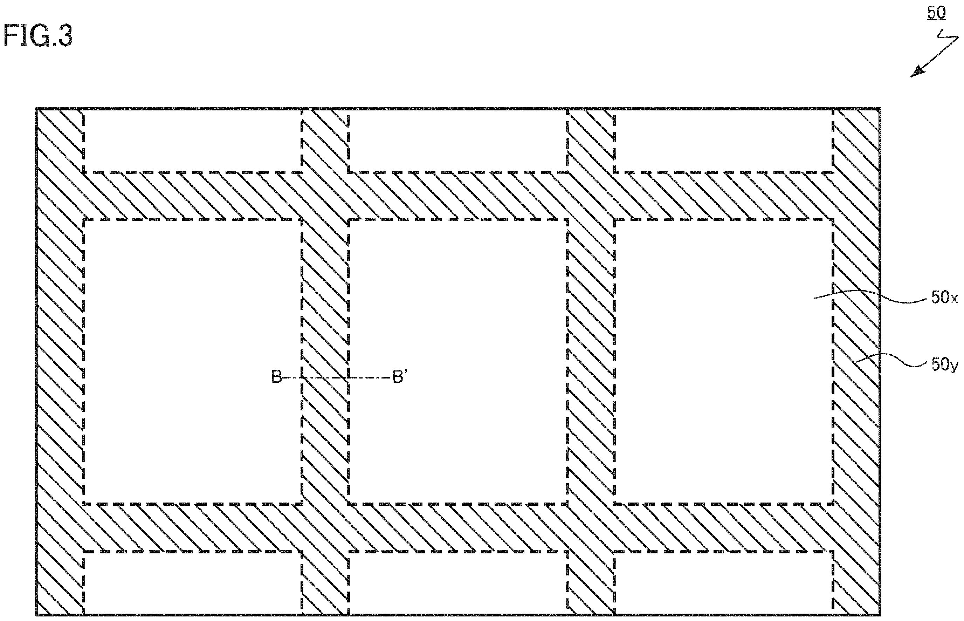

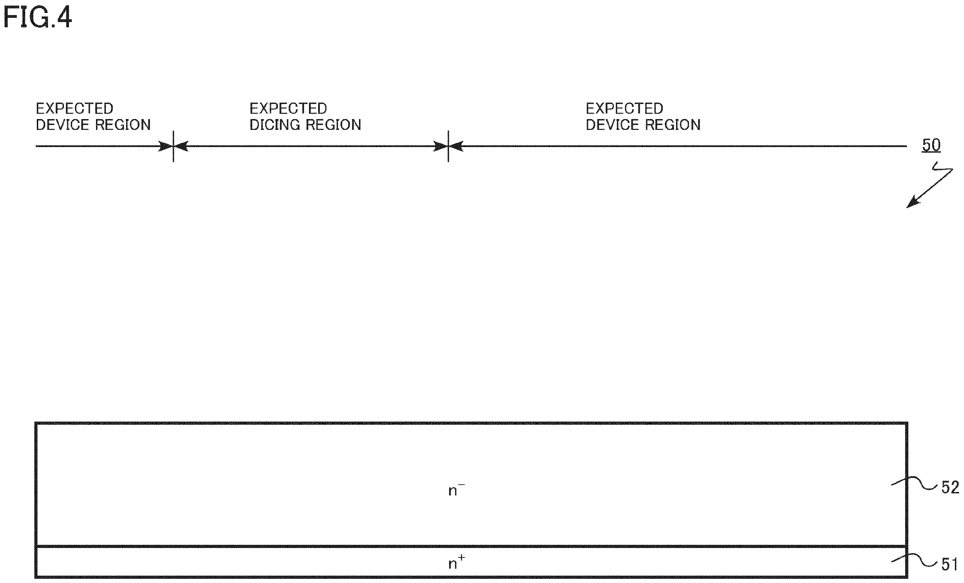

FIGS. 3 to 14 are diagrams that describe the method for manufacturing the semiconductor device according to the first embodiment. FIG. 3 is a top view of part of a semiconductor substrate used for manufacturing the semiconductor device according to the first embodiment. FIGS. 4 to 14 are schematic cross-sectional views showing a process of manufacturing the semiconductor device according to the first embodiment. FIGS. 4 to 14 are cross-sectional views of the semiconductor substrate along the line B-B' shown in FIG. 3.

First, a silicon carbide substrate 50 is prepared (FIG. 3). The silicon carbide substrate 50 is, for example, a silicon carbide wafer.

The silicon carbide substrate 50 includes an expected device region 50x and an expected dicing region 50y. The expected dicing region 50y surrounds the expected device region 50x. The expected device region 50x eventually becomes the device region 100x. Furthermore, a portion of the expected dicing region 50y eventually becomes the dicing region 100y.

The silicon carbide substrate 50 includes an n⁺-type substrate layer 51 and an n⁻-type first silicon carbide layer 52 (FIG. 4). The first silicon carbide layer 52 is, for example, an epitaxial growth layer formed on the substrate layer 51 by the epitaxial growth method. The first silicon carbide layer 52 eventually becomes the lower region 24a of the drift region 24.

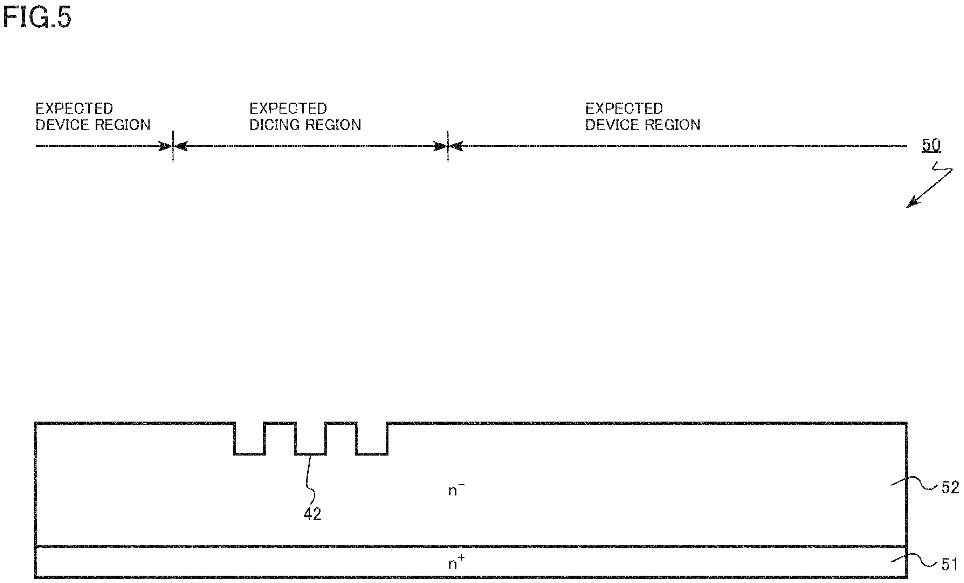

Next, the alignment mark 42 is formed on the expected dicing region 50y of the silicon carbide substrate 50 (FIG. 5). The alignment mark 42 is formed on the surface of the first silicon carbide layer 52. The alignment mark 42 is an example of a recess. It is noted that the alignment mark 42 can be a protrusion.

The alignment mark 42 is formed by, for example, formation of a patterned mask material (not shown) and etching using a reactive ion etching (RIE) method.

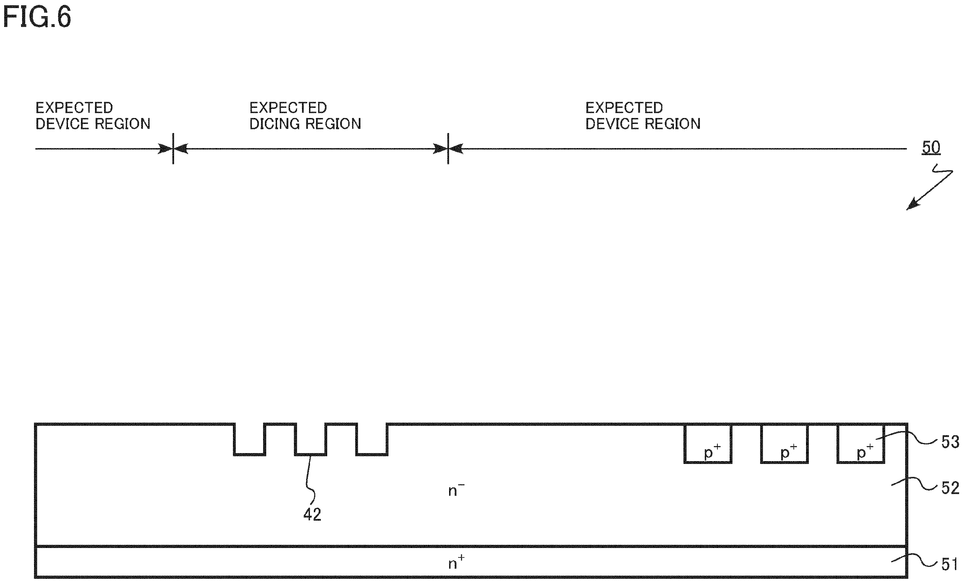

Next, a p⁺-type first SiC region 53 is formed in the expected device region 50x of the silicon carbide substrate 50 (FIG. 6). The first SiC region 53 is formed on the surface of the first silicon carbide layer 52. The first SiC region 53 is formed by, for example, ion implantation of aluminum. The first SiC region 53 eventually becomes the p⁺-type electric field relaxation region 30.

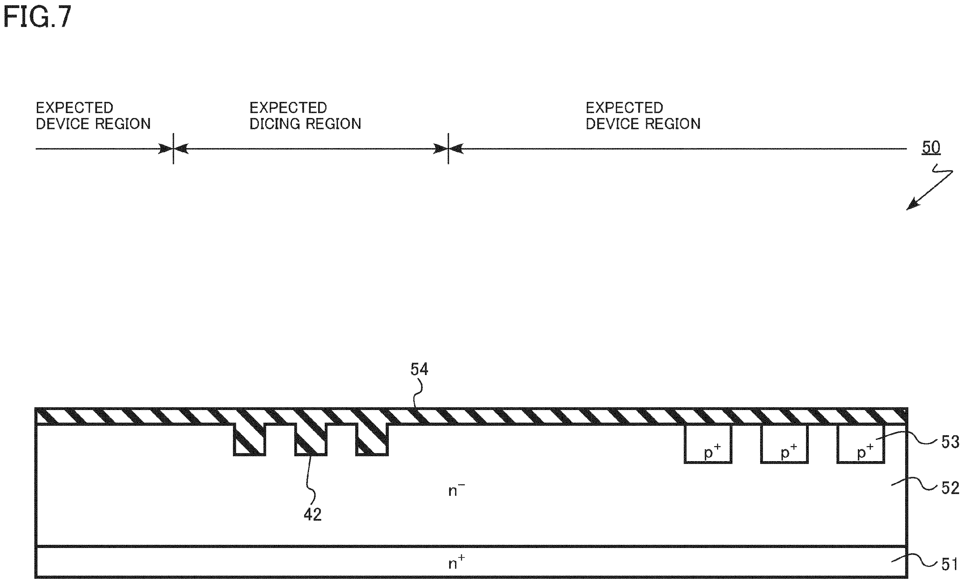

Next, a mask material 54 for covering the alignment mark 42 in the expected dicing region 50y is formed (FIG. 7). The mask material 54 is formed by, for example, a chemical vapor deposition (CVD) method. The mask material 54 is, for example, carbon or silicon nitride. More preferably, the mask material 54 includes a constituent element of gas (such as SiH₄, C₃H₈, H₂, N₂, or trimethylaluminum) used in epitaxial growth to be described later or a constituent element of a member of an epitaxial growth furnace made of a material such as carbon or poly-SiC.

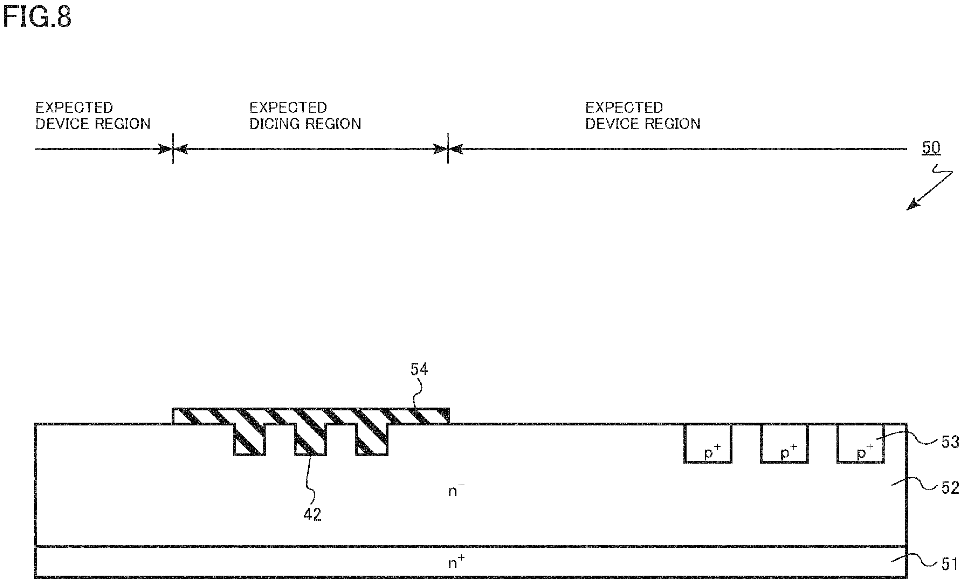

Next, the mask material 54 in the expected device region 50x is removed (FIG. 8). The mask material 54 in the expected device region 50x is removed by, for example, patterning using a photolithography method and a wet etching method or a dry etching method. The mask material 54 on at least the alignment mark 42 on the surface of the expected dicing region 50y remains.

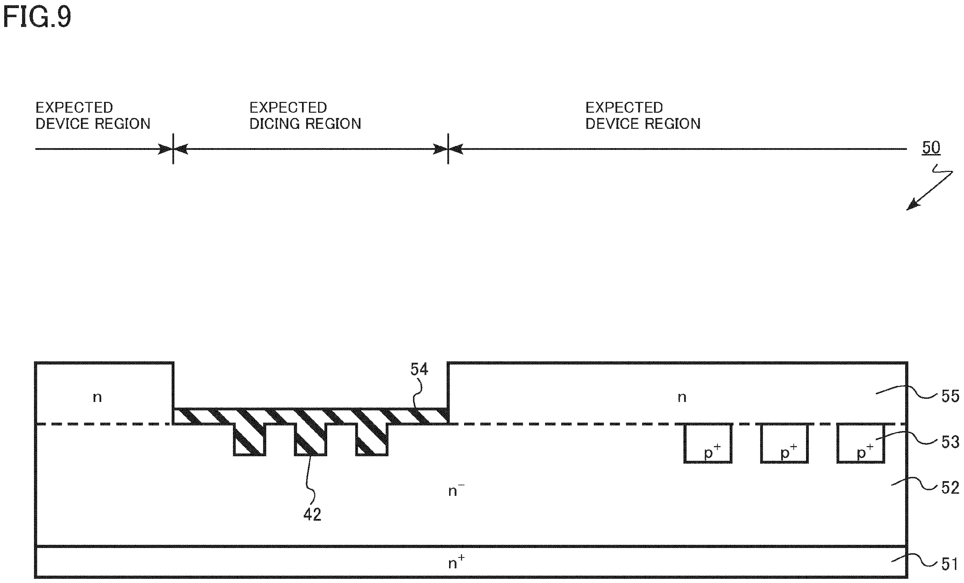

Next, a second silicon carbide layer 55 is formed on the first silicon carbide layer 52 (FIG. 9). The second silicon carbide layer 55 is formed on the first silicon carbide layer 52 by the epitaxial growth method. The second silicon carbide layer 55 is an epitaxial growth layer.

The second silicon carbide layer 55 is not formed in the expected dicing region 50y where the first silicon carbide layer 52 is covered with the mask material 54. The second silicon carbide layer 55 is selectively formed on the expected device region 50x. A portion of the second silicon carbide layer 55 eventually becomes the upper region 24b of the drift region 24.

Next, the mask material 54 in the expected dicing region 50y is removed. The mask material 54 in the expected dicing region 50y is removed by, for example, the wet etching method or the dry etching method.

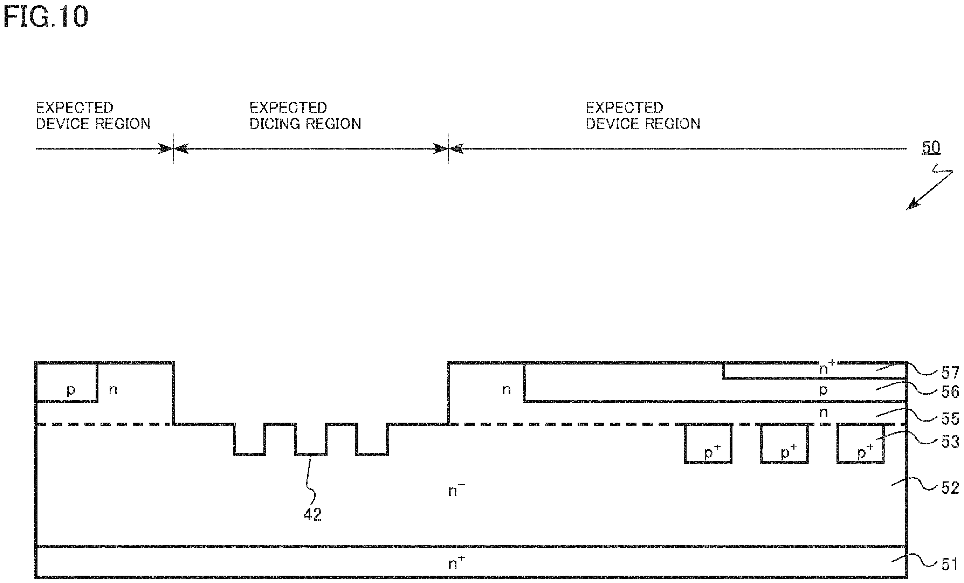

Next, a p-type second SiC region 56 is formed by, for example, ion implantation of aluminum. Furthermore, an n⁺-type third SiC region 57 is formed by, for example, ion implantation of phosphorus (FIG. 10).

The second SiC region 56 eventually becomes the p-type body region 26. Furthermore, the third SiC region 57 eventually becomes the n⁺-type source region 28.

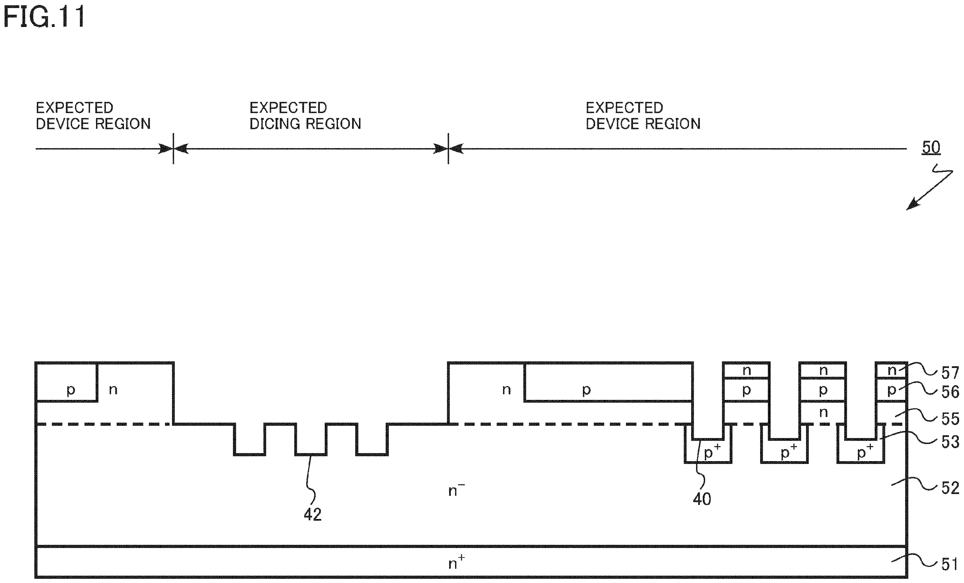

Next, the trench 40 that penetrates through the third SiC region 57 and the second SiC region 56 and reaches the first SiC region 53 is formed (FIG. 11). The trench 40 is formed by, for example, deposition of a mask material by the CVD method, patterning of the mask material by the photolithography method and the RIE method, and etching of the silicon carbide layer using the RIE method.

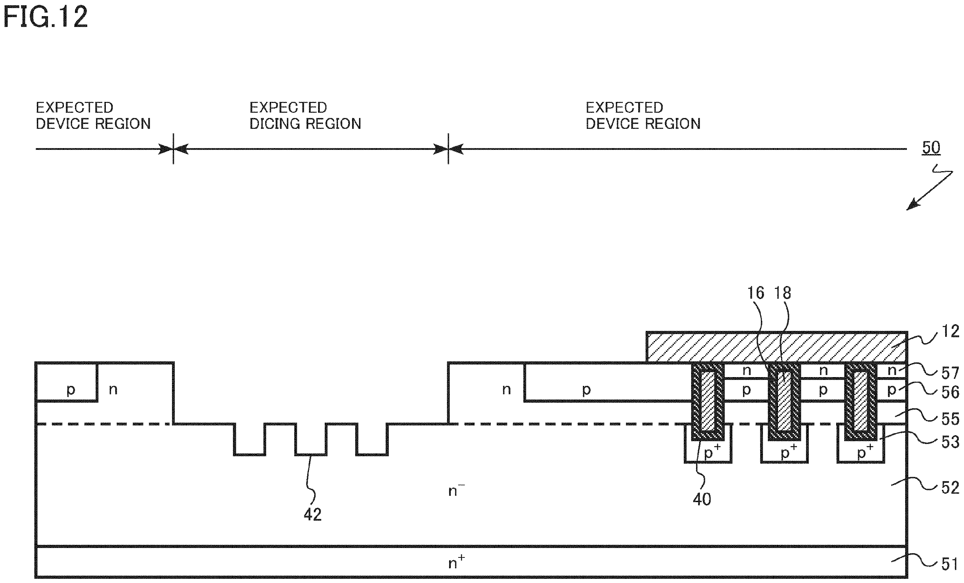

Next, by using known process technology, the gate insulating layer 16, the gate electrode 18, and the source electrode 12 are formed in the expected device region 50x (FIG. 12).

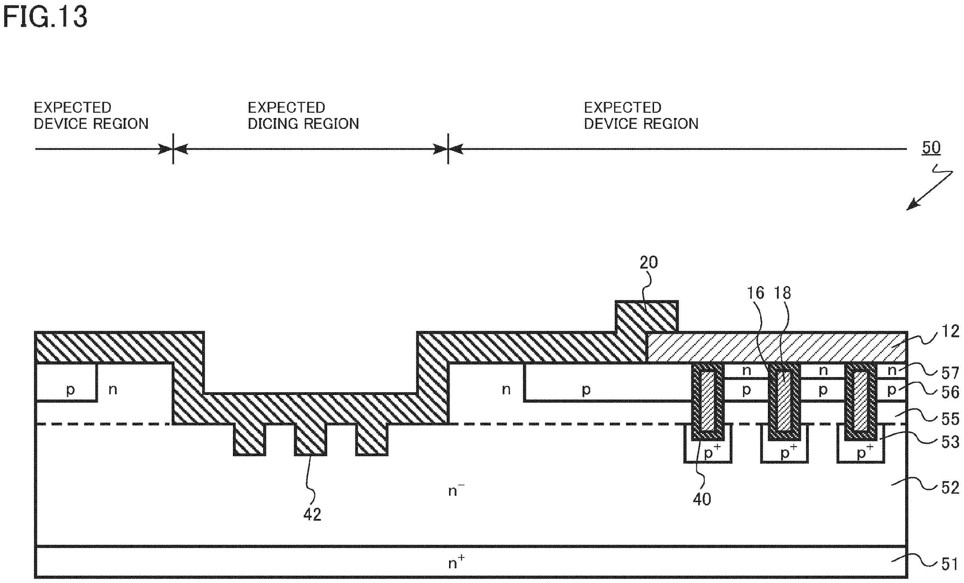

Next, by using known process technology, the protective insulating layer 20 is formed on the source electrode 12 (an electrode) and the second silicon carbide layer 55 in the expected device region 50x. Furthermore, the protective insulating layer 20 is formed on the first silicon carbide layer 52 and the alignment mark 42 in the expected dicing region 50y (FIG. 13). After that, by using known process technology, the drain electrode 14 is formed.

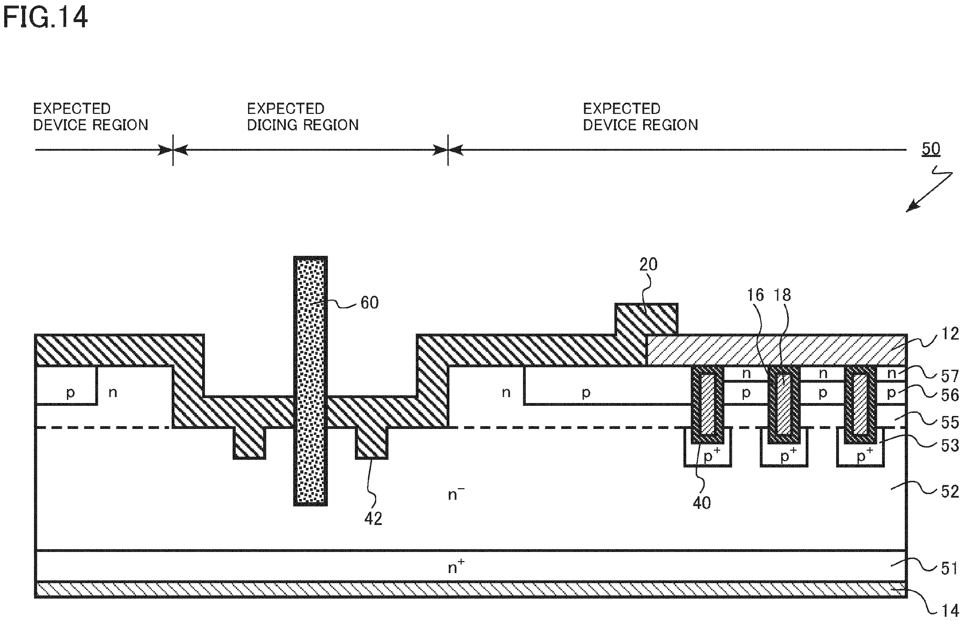

Next, the expected dicing region 50y is cut, for example, with a dicing blade 60, and the silicon carbide substrate 50 is divided into a plurality of MOSFETs 100 (FIG. 14).

By the above manufacturing method, the MOSFET 100 shown in FIGS. 1 and 2 is formed.

Subsequently, the function and effect of the semiconductor device and its manufacturing method according to the first embodiment are described.

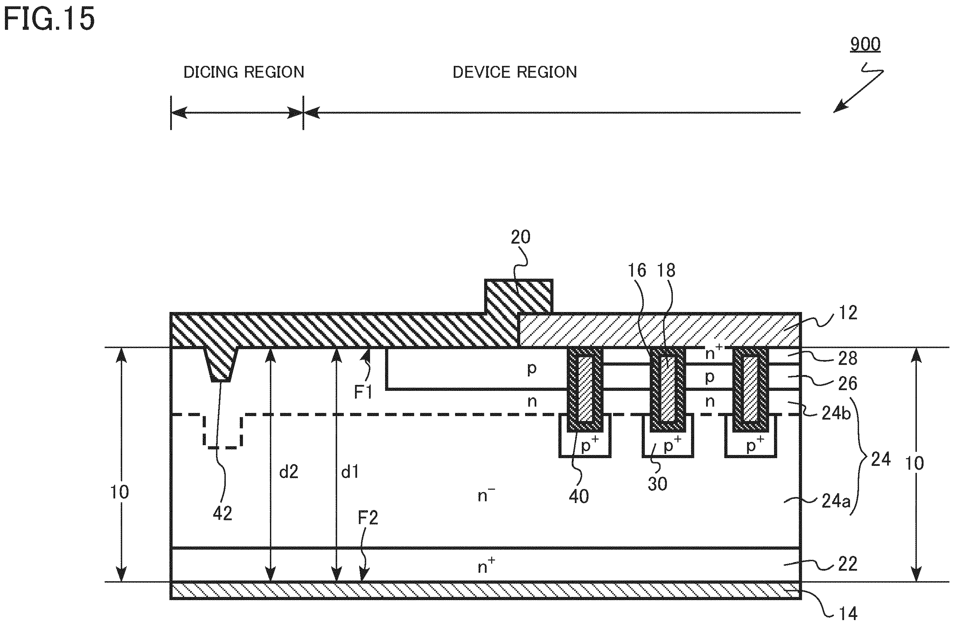

FIG. 15 is a schematic cross-sectional view of a semiconductor device according to a comparative example. FIG. 15 is a diagram corresponding to FIG. 1 for the first embodiment.

The semiconductor device according to the comparative example is a vertical MOSFET 900 using silicon carbide. The MOSFET 900 according to the comparative example differs from the MOSFET 100 according to the first embodiment in that the first maximum distance (d1 in FIG. 15) from the second face F2 to the first face F1 of the device region in the normal direction of the second face F2 is equal to the second maximum distance (d2 in FIG. 15) from the second face F2 to the first face F1 of the dicing region in the normal direction of the second face F2.

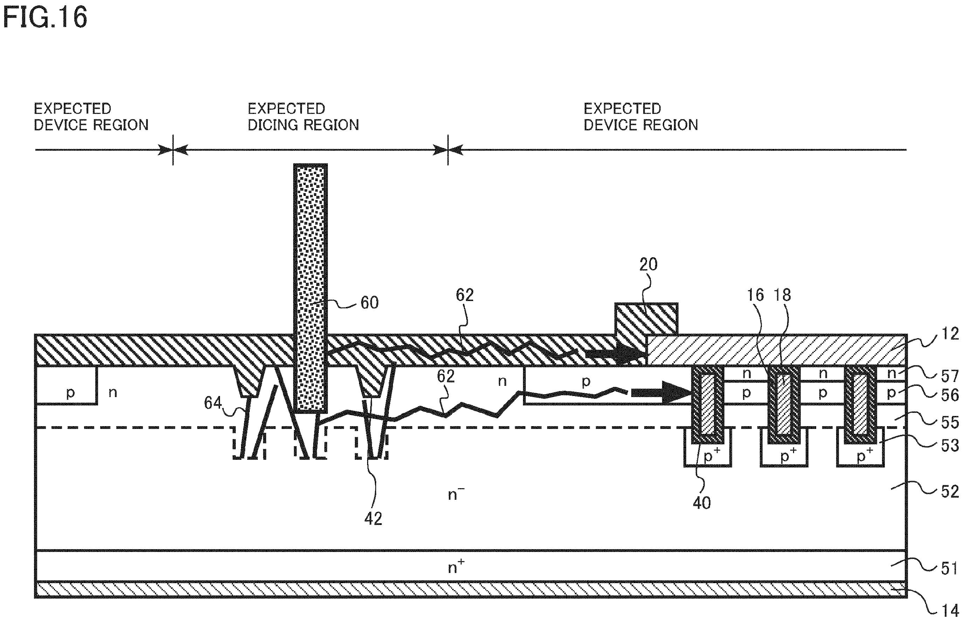

FIG. 16 is a diagram that describes a problem of the semiconductor device and its manufacturing method according to the comparative example.

FIG. 16 is a diagram that describes a case where an expected dicing region of the MOSFET 900 according to the comparative example is cut, for example, with the dicing blade 60. FIG. 16 is a diagram corresponding to FIG. 14 for the first embodiment.

A method for manufacturing the MOSFET 900 according to the comparative example differs from that for the MOSFET 100 according to the first embodiment in that the second silicon carbide layer 55 is formed in the expected dicing region as well. The MOSFET 900 differs from the MOSFET 100 according to the first embodiment in that there is the second silicon carbide layer 55 that is an epitaxial growth layer in the expected dicing region as well.

In a manufacturing method similar to that of the MOSFET 100 according to the first embodiment, by not forming the mask material 54 in the expected dicing region, the second silicon carbide layer 55 that is an epitaxial growth layer can be made grow in the expected dicing region as well.

As a result, as shown in FIGS. 15 and 16, there is no step on the surface of the silicon carbide layer 10 between the device region and the dicing region. There is no step on the first face F1 of the silicon carbide layer 10 between the device region and the dicing region.

In the MOSFET 900 according to the comparative example, when the expected dicing region is cut with the dicing blade 60, as shown in FIG. 16, there is a possibility that a crack 62 may be produced in the protective insulating layer 20 due to mechanical stress. If the crack 62 produced in the protective insulating layer 20 extends from the dicing region to the device region, moisture and mobile ions enter the device region through the crack 62 when the MOSFET 900 is running. There is a possibility that the moisture and mobile ions having entered the device region may cause, for example, degradation of device characteristics or short circuit failure of the MOSFET 900. Therefore, there is a possibility that the reliability of the MOSFET 900 may decrease.

Furthermore, when the MOSFET 900 according to the comparative example is manufactured, the second silicon carbide layer 55 that is an epitaxial growth layer is formed on the alignment mark 42 provided in the expected dicing region as well. Since the alignment mark 42 is a recess or a protrusion, the crystallinity of the epitaxial growth layer above the alignment mark 42 decreases. For example, as shown in FIG. 16, a crystal defect 64 is formed in the epitaxial growth layer above the alignment mark 42.

In the MOSFET 900 according to the comparative example, when the expected dicing region is cut with the dicing blade 60, as shown in FIG. 16, there is a possibility that from the crystal defect 64 as a starting point, a crack 62 may be produced in the silicon carbide layer due to mechanical stress. If the crack 62 produced in the silicon carbide layer extends from the dicing region to the device region, moisture and mobile ions enter the device region through the crack 62 when the MOSFET 900 is running. There is a possibility that the moisture and mobile ions having entered the device region may cause degradation of device characteristics of the MOSFET 900. Therefore, there is a possibility that the reliability of the MOSFET 900 may decrease.

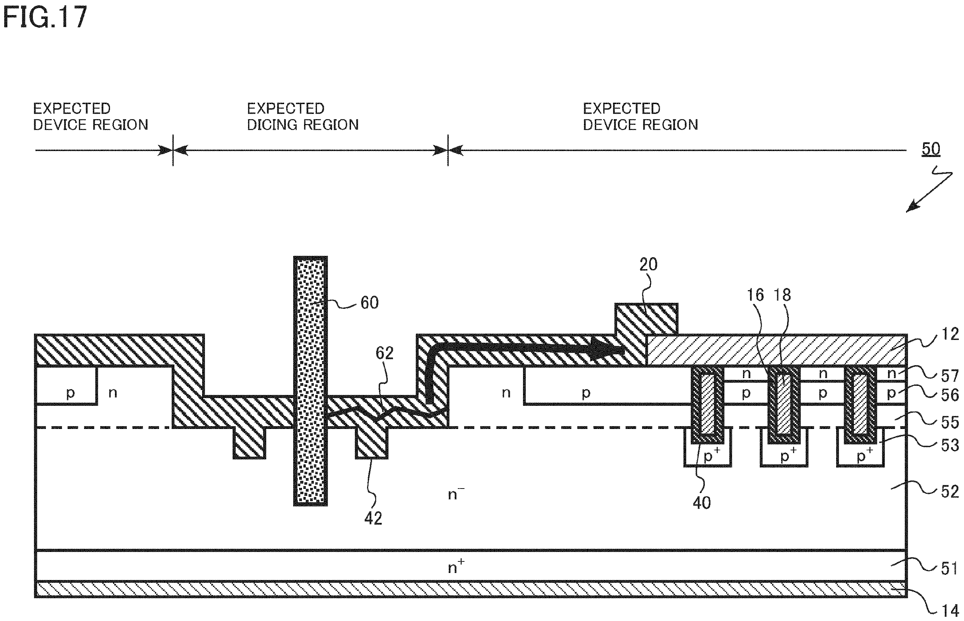

FIG. 17 is a diagram that describes the function and effect of the semiconductor device and its manufacturing method according to the first embodiment. FIG. 17 is a diagram corresponding to FIG. 14 for the first embodiment.

In the MOSFET 100 according to the first embodiment, there is a step on the surface of the silicon carbide layer 10 between the device region 100x and the dicing region 100y.

Also in the MOSFET 100 according to the first embodiment, when the expected dicing region is cut with the dicing blade 60, as shown in FIG. 17, there is a possibility that a crack 62 may be produced in the protective insulating layer 20 due to mechanical stress. However, since there is the step on the surface of the silicon carbide layer 10, as shown in FIG. 17, the crack 62 is prevented from extending from the dicing region 100y to the device region 100x.

Furthermore, for example, a pathway (a black arrow in FIG. 17) for the moisture and mobile ions having entered the end of the crack 62 to further enter the inside of the device region 100x through the protective insulating layer 20 is effectively made longer by the presence of the step.

Therefore, in the MOSFET 100 according to the first embodiment, the entry of the moisture and mobile ions into the device region 100x is prevented. Thus, the reliability of the MOSFET 100 is improved.

Moreover, an interlayer insulating film including silicon oxide or the like may be provided between the source electrode 12 and the outermost surface of the first face F1, for example, between the source electrode 12 and the gate electrode 18, and the interlayer insulating film may be provided to extend from the first face F1 of the device region 100x to the first face F1 of the dicing region 100y. In that case, the protective insulating layer 20 is disposed on at least a portion of the interlayer insulating film, which can further prevent the entry of the moisture and mobile ions into the device region 100x. Thus, the reliability of the MOSFET 100 is improved.

Furthermore, when the MOSFET 100 according to the first embodiment is manufactured, the second silicon carbide layer 55 that is an epitaxial growth layer is not formed on the alignment mark 42 provided in the expected dicing region. Therefore, the problem caused by the crystal defect 64 of the epitaxial growth layer that becomes apparent in the MOSFET 900 according to the comparative example is prevented. Thus, the reliability of the MOSFET 100 is improved.

In the MOSFET 100 according to the first embodiment, from the viewpoint of preventing the crack 62 from extending to the device region 100x, the difference between the first maximum distance d1 and the second maximum distance d2 is preferably equal to or more than 0.5 um, more preferably equal to or more than 1 µm, and still more preferably equal to or more than 2 µm.

As described above, in the MOSFET 900 according to the comparative example, the second silicon carbide layer 55 that is an epitaxial growth layer is formed on the alignment mark 42. Therefore, as shown in FIG. 15, there is a possibility that the shape of the alignment mark 42 may be changed from the shape before the epitaxial growth layer is formed. If the shape of the alignment mark 42 is changed, there is a possibility that the accuracy of alignment between patterns in the photolithography step may be reduced.

In the MOSFET 100 according to the first embodiment, the second silicon carbide layer 55 that is an epitaxial growth layer is not formed on the alignment mark 42. Thus, the shape of the alignment mark 42 is not changed. Therefore, the accuracy of alignment between patterns in the photolithography step is prevented from being reduced.

### (Modification Example)

A semiconductor device according to a modification example of the first embodiment differs from the semiconductor device according to the first embodiment in that the device region includes a first region and a second region surrounding the first region and provided along the dicing region, and the maximum distance from the second face to the first face of the second region in the normal direction is greater than the maximum distance from the second face to the first face of the first region in the normal direction.

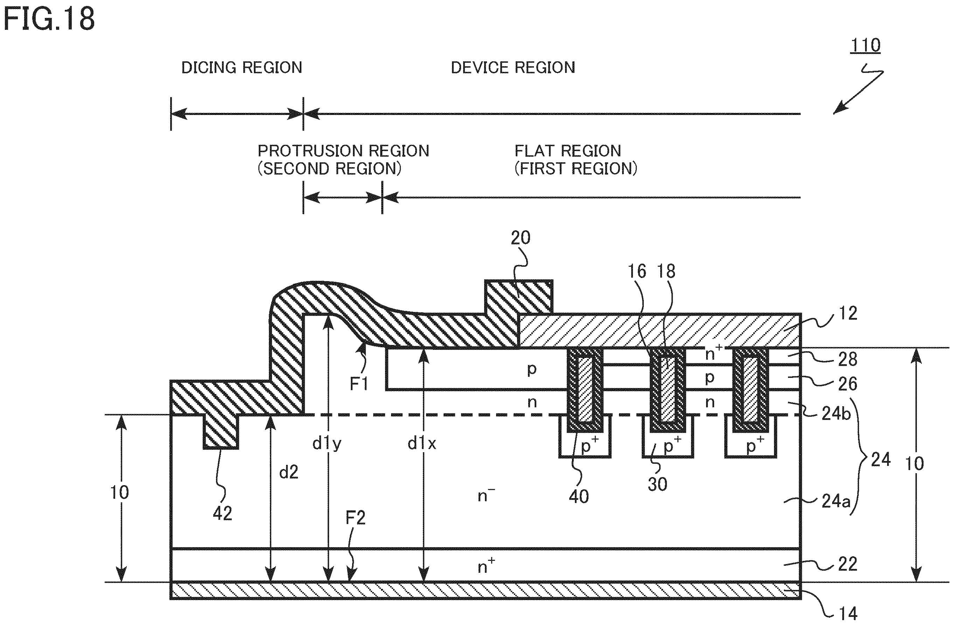

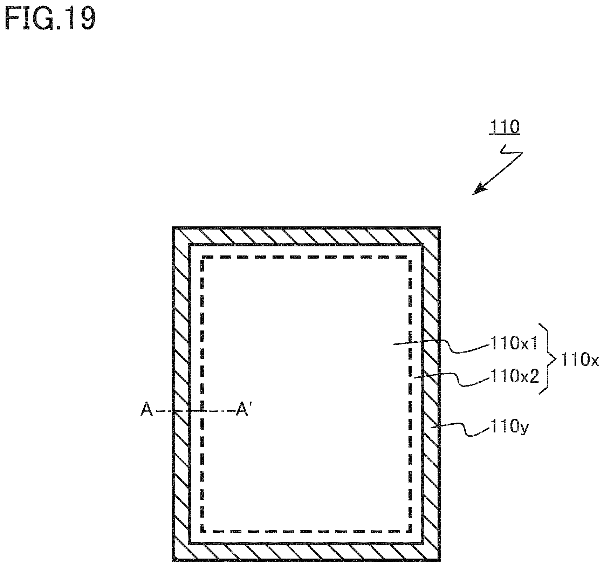

FIGS. 18 and 19 are schematic diagrams of the semiconductor device according to the modification example of the first embodiment. FIG. 18 is a schematic cross-sectional view of part of the semiconductor device according to the modification example of the first embodiment. FIG. 19 is a top view of the semiconductor device according to the modification example of the first embodiment. FIG. 18 is a cross-sectional view of the semiconductor device along the line A-A' shown in FIG. 19.

The semiconductor device according to the modification example of the first embodiment is a vertical MOSFET 110 using silicon carbide.

The MOSFET 110 includes a device region 110x and a dicing region 110y. The dicing region 110y surrounds the device region 110x.

The device region 110x has a flat region 110x1 and a protrusion region 110x2. The flat region 110x1 is an example of the first region. The protrusion region 110x2 is an example of the second region.

The protrusion region 110x2 surrounds the flat region 110x1. The protrusion region 110x2 is provided along the dicing region 110y. The protrusion region 110x2 is provided along the end of the device region 110x.

Since the device region 110x includes the protrusion region 110x2, the silicon carbide layer 10 becomes thicker toward the dicing region 110y.

The maximum distance (d1y in FIG. 18) from the second face F2 to the first face F1 of the protrusion region 110x2 in the normal direction of the second face F2 is greater than the maximum distance (dix in FIG. 18) from the second face F2 to the first face F1 of the flat region 110x1 in the normal direction of the second face F2. A difference between the maximum distance d1y and the maximum distance dix is, for example, equal to or more than 0.2 um and equal to or less than 1 um.

For example, the MOSFET 110 can be manufactured by a manufacturing method similar to that of the MOSFET 100 according to the first embodiment. By controlling conditions for film formation when the second silicon carbide layer 55 is formed on the first silicon carbide layer 52 by the epitaxial growth method, it becomes possible to make the second silicon carbide layer 55 formed on the end of the expected device region thicker to form the protrusion region 110x2.

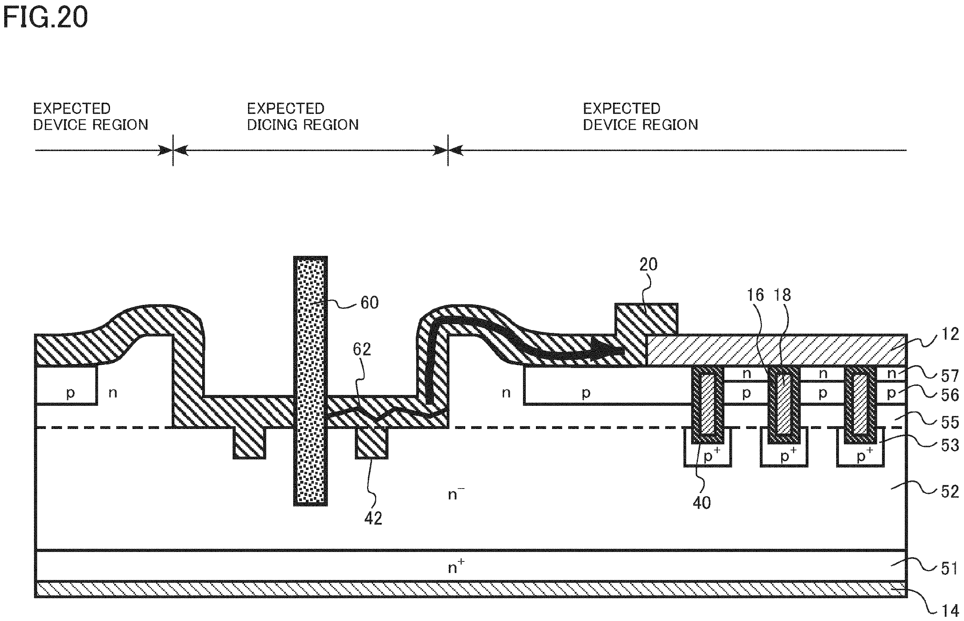

FIG. 20 is a diagram that describes the function and effect of the semiconductor device and its manufacturing method according to the modification example of the first embodiment. FIG. 20 is a diagram corresponding to FIG. 17 for the first embodiment.

In the MOSFET 110 according to the modification example of the first embodiment, there is a step on the surface of the silicon carbide layer 10 between the device region 110x and the dicing region 110y. Furthermore, the protruding region 110x2 is provided on the end of the device region 110x, which makes step height or difference in level larger than, for example, that of the MOSFET 100 according to the first embodiment.

Also in the MOSFET 110 according to the modification example of the first embodiment, when the expected dicing region is cut with the dicing blade 60, as shown in FIG. 20, there is a possibility that a crack 62 may be produced in the protective insulating layer 20 due to mechanical stress. However, since there is a step on the surface of the silicon carbide layer 10, as shown in FIG. 20, the crack 62 is prevented from extending from the dicing region 110y to the device region 110x.

Furthermore, for example, a pathway (a black arrow in FIG. 20) for the moisture and mobile ions having entered the end of the crack 62 to further enter the inside of the device region 110x through the protective insulating layer 20 is effectively made longer by the presence of the step.

Therefore, in the MOSFET 110 according to the modification example of the first embodiment, the entry of the moisture and mobile ions into the device region 110x is prevented. Thus, the reliability of the MOSFET 110 is improved.

As described above, according to the first embodiment and its modification example, it is possible to realize a semiconductor device with improved reliability and its manufacturing method.

### (Second Embodiment)

A semiconductor device according to a second embodiment differs from the semiconductor device according to the first embodiment in that the device region further includes an insulating layer provided on the first electrode, and at least a portion of the outermost surface of the dicing region on the side of the first face is the silicon carbide layer.

Furthermore, a method for manufacturing the semiconductor device according to the second embodiment differs from that for the semiconductor device according to the first embodiment in that an electrode is formed on the second silicon carbide layer, an insulating layer is formed on the electrode, and the insulating layer in the expected dicing region is removed to expose the first silicon carbide layer.

Hereinafter, the description of some contents of the semiconductor device or its manufacturing method that overlap with the first embodiment may be omitted.

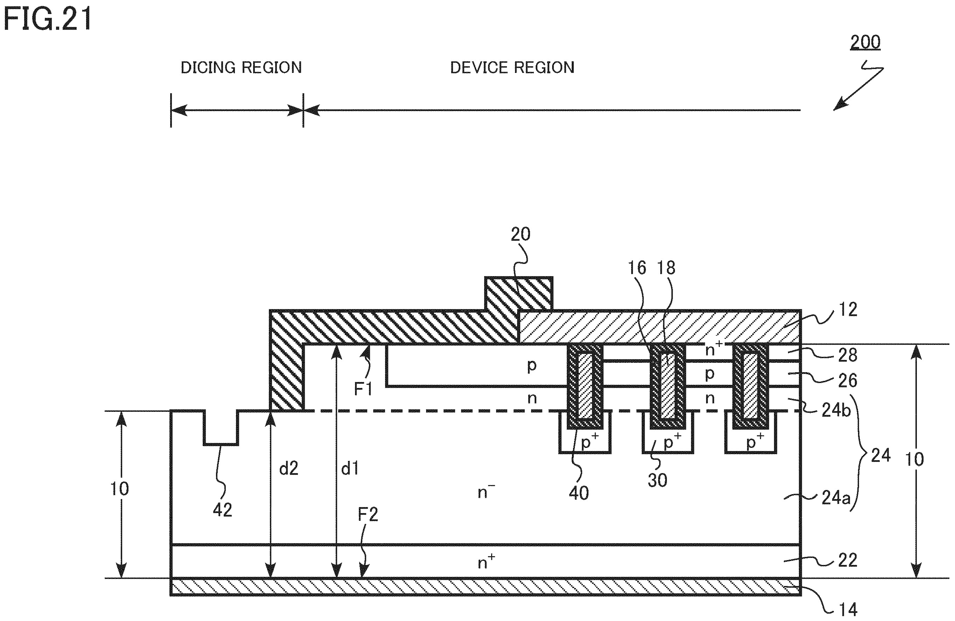

FIG. 21 is a schematic diagram of the semiconductor device according to the second embodiment. FIG. 21 is a schematic cross-sectional view of part of the semiconductor device according to the second embodiment. FIG. 21 is a diagram corresponding to FIG. 1 for the first embodiment.

The semiconductor device according to the second embodiment is a vertical MOSFET 200 using silicon carbide. The MOSFET 200 is a trench gate type MOSFET with a gate electrode formed in a trench.

In the MOSFET 200, as shown in FIG. 21, there is no protective insulating layer 20 on at least a portion of the outermost surface on the side of the dicing region. In the MOSFET 200, at least a portion of the outermost surface on the side of the dicing region is the silicon carbide layer 10. In the MOSFET 200, at least a portion of the outermost surface on the side of the dicing region is the first face F1 of the silicon carbide layer 10.

In the MOSFET 200, the lower region 24a of the drift region 24 is exposed on at least a portion of the dicing region. In the MOSFET 200, for example, the alignment mark 42 is exposed on the surface.

In the MOSFET 200, the outermost surface of the device region on the side of the first face F1 is, for example, the source electrode 12 or the protective insulating layer 20. And, at least a portion of the outermost surface of the dicing region on the side of the first face F1 is the silicon carbide layer 10.

For example, the MOSFET 200 can be manufactured by a manufacturing method similar to that of the MOSFET 100 according to the first embodiment. However, after the protective insulating layer 20 is formed on the source electrode 12, the protective insulating layer 20 in the expected dicing region is removed.

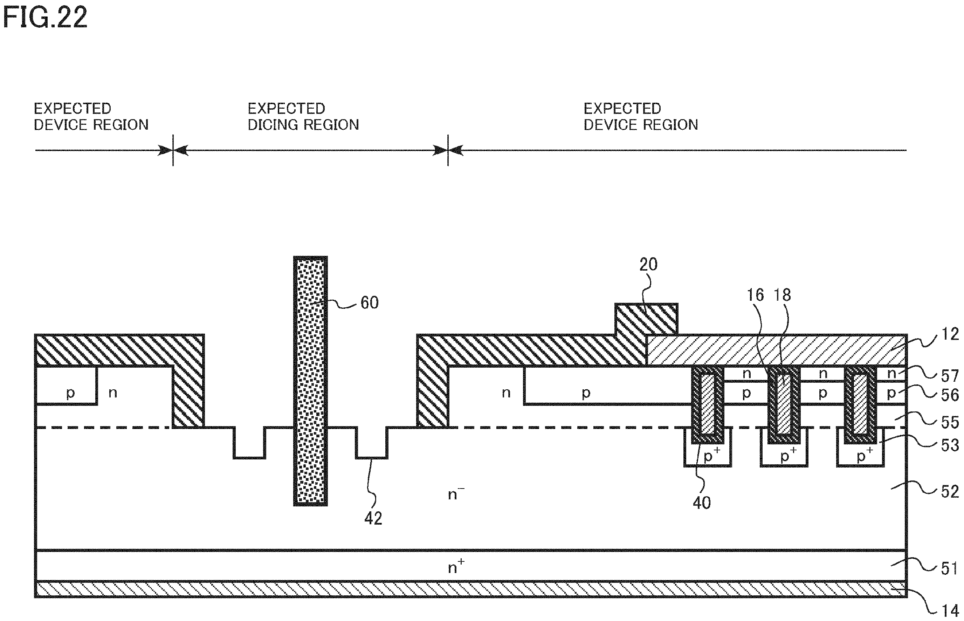

FIG. 22 is a diagram that describes the function and effect of the semiconductor device and its manufacturing method according to the second embodiment. FIG. 22 is a diagram corresponding to FIG. 17 for the first embodiment.

In the MOSFET 200 according to the second embodiment, there is no protective insulating layer 20 on at least a portion of the outermost surface on the side of the dicing region. For example, there is no protective insulating layer 20 in a region in contact with the dicing blade 60 in the expected dicing region. Thus, when the expected dicing region is cut with the dicing blade 60, the protective insulating layer 20 is prevented from being cracked.

Therefore, in the MOSFET 200 according to the second embodiment, the entry of the moisture and mobile ions into the device region is prevented. Thus, the reliability of the MOSFET 200 is improved.

As described above, according to the second embodiment, it is possible to realize a semiconductor device with improved reliability and its manufacturing method.

### (Third Embodiment)

A method for manufacturing a semiconductor device according to a third embodiment includes: forming a second silicon carbide layer on a silicon carbide substrate by using an epitaxial growth method, the silicon carbide substrate having an expected device region and an expected dicing region surrounding the expected device region and including a first silicon carbide layer; forming a mask material for covering the expected device region; and with the mask material as a mask, removing the second silicon carbide layer on the expected dicing region and exposing the first silicon carbide layer. The method for manufacturing the semiconductor device according to the third embodiment differs from that for the semiconductor device according to the first embodiment in that after the second silicon carbide layer is formed on the expected dicing region, the second silicon carbide layer on the expected dicing region is removed. Hereinafter, the description of some contents that overlap with the first embodiment may be omitted.

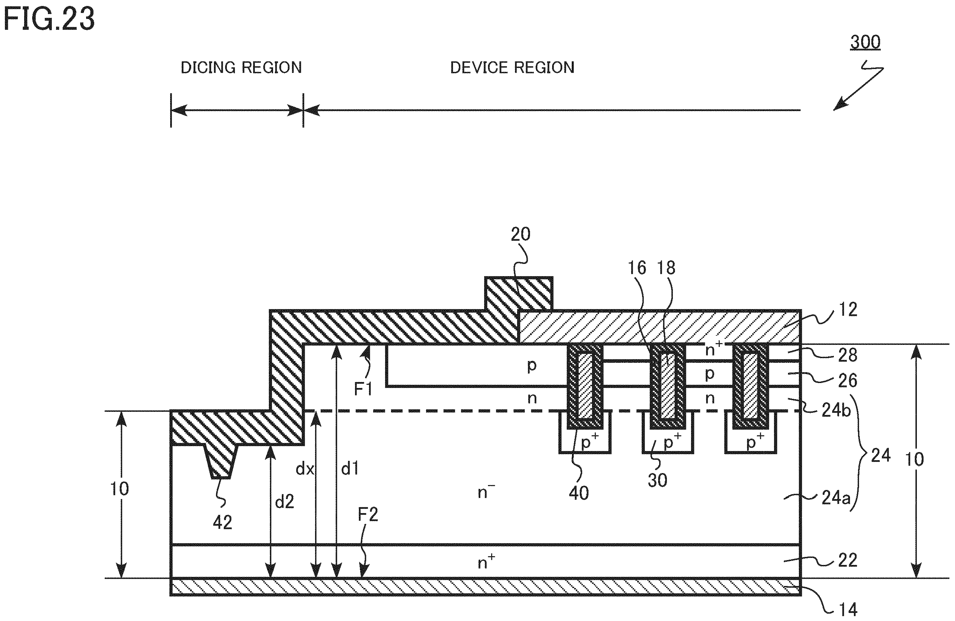

FIG. 23 is a schematic diagram of the semiconductor device according to the third embodiment. FIG. 23 is a schematic cross-sectional view of part of the semiconductor device according to the third embodiment. FIG. 23 is a diagram corresponding to FIG. 1 for the first embodiment.

The semiconductor device according to the third embodiment is a vertical MOSFET 300 using silicon carbide. The MOSFET 300 is a trench gate type MOSFET with a gate electrode formed in a trench.

The MOSFET 300 differs from the MOSFET 100 according to the first embodiment in that, as shown in FIG. 23, the distance (dx in FIG. 23) from the second face F2 of the device region to a boundary between the lower region 24a and the upper region 24b in the normal direction of the second face F2 is greater than the second maximum distance (d2 in FIG. 23) from the second face F2 to the first face F1 of the dicing region in the normal direction of the second face F2. Other than that, the MOSFET 300 has a similar structure to the MOSFET 100 according to the first embodiment.

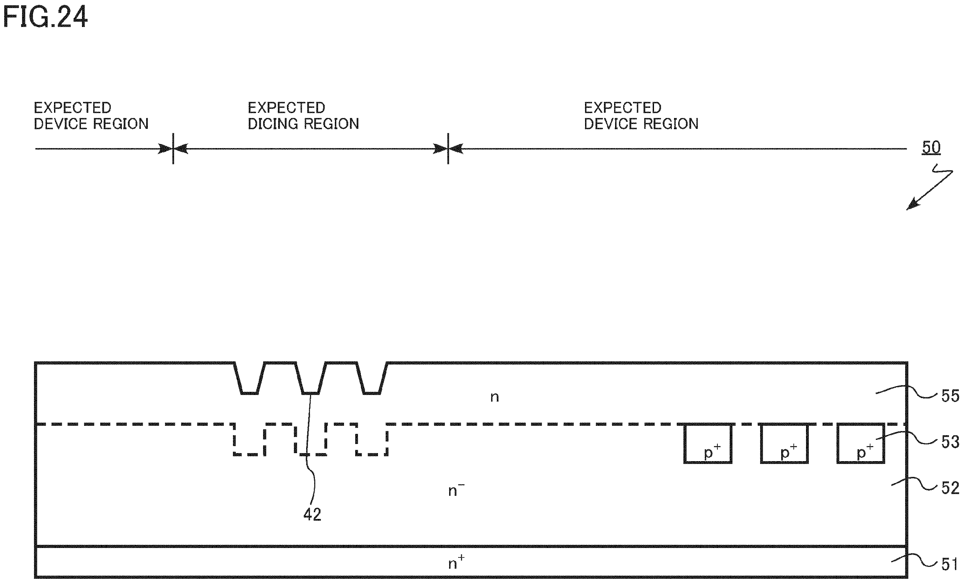

FIGS. 24 to 26 are diagrams that describe the method for manufacturing the semiconductor device according to the third embodiment. FIGS. 24 to 26 are schematic cross-sectional views showing a process of manufacturing the semiconductor device according to the third embodiment.

Processes from preparing the silicon carbide substrate 50 first until forming the p⁺-type first SiC region 53 in the expected device region of the silicon carbide substrate 50 are similar to the method for manufacturing the MOSFET 100 according to the first embodiment.

Next, the second silicon carbide layer 55 is formed on the first silicon carbide layer 52 (FIG. 24). The second silicon carbide layer 55 is formed on the first silicon carbide layer 52 by the epitaxial growth method. The second silicon carbide layer 55 is an epitaxial growth layer.

The second silicon carbide layer 55 is formed on the expected dicing region as well, and the shape of the alignment mark 42 is transferred to the surface of the second silicon carbide layer 55.

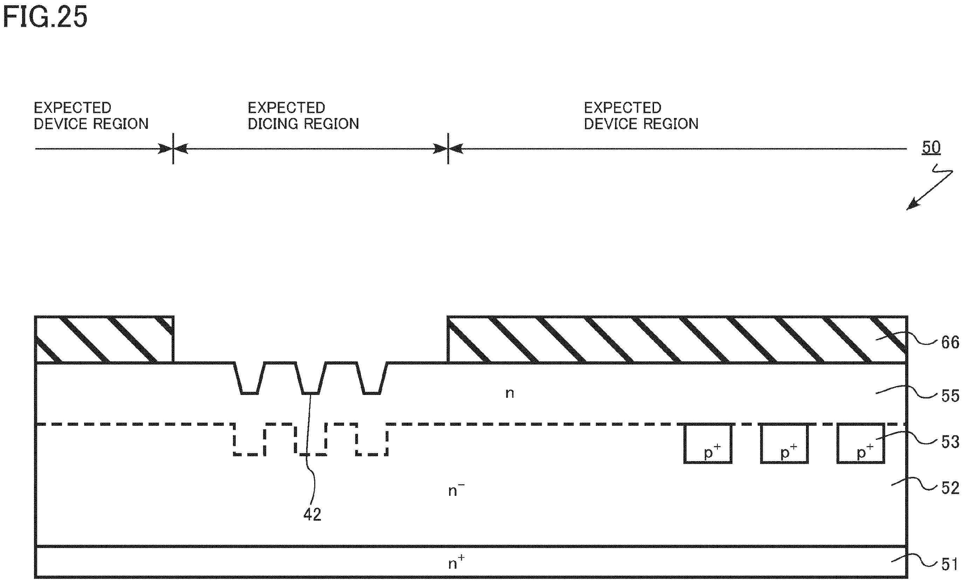

Next, a mask material 66 for covering the expected device region is formed (FIG. 25). The mask material 66 is, for example, silicon nitride.

The mask material 66 is formed by, for example, film formation by the CVD method, the photolithography method, and the RIE method.

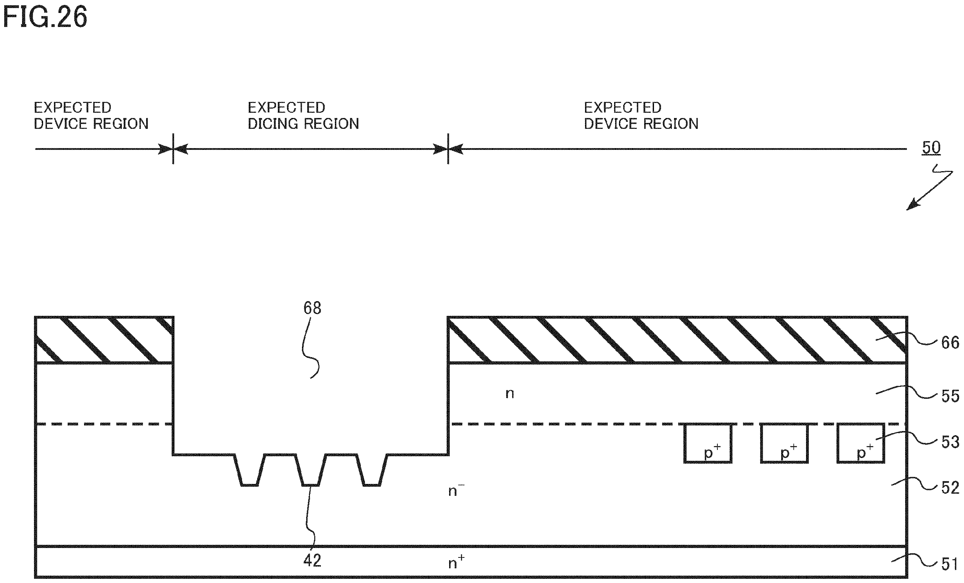

Next, with the mask material 66 as a mask, the second silicon carbide layer 55 in the expected dicing region is etched to form a recess region 68 (FIG. 26). For example, the recess region 68 reaches the first silicon carbide layer 52. The shape of the alignment mark 42 is transferred to a bottom surface of the recess region 68.

After that, the mask material 66 is removed by, for example, the wet etching method. Then, by a similar manufacturing method to that for the MOSFET 100 according to the first embodiment, the p-type body region 26, the n⁺-type source region 28, the trench 40, the gate insulating layer 16, the gate electrode 18, the source electrode 12, the protective insulating layer 20, and the drain electrode 14 are formed.

Next, the expected dicing region is cut, for example, with a dicing blade, and the silicon carbide substrate 50 is divided into a plurality of MOSFETs 300.

By the manufacturing method described above, the MOSFET 300 shown in FIG. 23 is formed.

In the method for manufacturing the MOSFET 300 according to the third embodiment, as with the MOSFET 100 according to the first embodiment, there is a step on the surface of the silicon carbide layer 10 between the dicing region and the device region. Therefore, a crack produced in the protective insulating layer 20 is prevented from extending from the dicing region to the device region. Thus, the reliability of the MOSFET 300 is improved.

In the method for manufacturing the MOSFET 300 according to the third embodiment, the second silicon carbide layer 55 that is an epitaxial growth layer is formed on the expected dicing region as well. Thus, there is a possibility that the crystallinity of the second silicon carbide layer 55 above the alignment mark 42 may be decrease.

However, the second silicon carbide layer 55 above the alignment mark 42 is removed by forming the recess region 68. Therefore, when the expected dicing region is cut with the dicing blade, the silicon carbide layer 10 is prevented from being cracked from a crystal defect as a starting point. Thus, the reliability of the MOSFET 300 is improved.

As described above, according to the third embodiment, it is possible to realize a semiconductor device with improved reliability and its manufacturing method.

In the first to third embodiments, there is described the case of using 4H-SiC as the crystal structure of SiC an example; however, the present disclosure can also be applied to devices using SiC of other crystal structures, such as 6H-SiC and 3C-SiC. Furthermore, a face other than the (0001) face can be used as the surface of the silicon carbide layer 10.

In the first to third embodiments, there is described the case where the first conductive type is the n-type, and the second conductive type is the p-type as an example; however, the first conductive type can be the p-type, and the second conductive type can be the n-type.

In the first to third embodiments, there is described the case where the semiconductor device is a trench gate type MOSFET as an example; however, the semiconductor device is not limited to a trench gate type MOSFET. For example, the semiconductor device may be a planar gate type MOSFET, an insulated gate bipolar transistor (IGBT), or a diode.

While certain embodiments have been described, these embodiments have been presented by way of example only, and are not intended to limit the scope of the inventions. Indeed, the semiconductor device and the method for manufacturing the semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (100,110,200,300) comprising:
a device region (100x); and
a dicing region (100y) surrounding the device region,
the device region (100x) including
a first electrode (12),
a second electrode (14), and
a silicon carbide layer (10) having a first face (F1) on a side of the first electrode (12) and a second face (F2) on a side of the second electrode (14), at least a portion of the silicon carbide layer (10) provided between the first electrode (12) and the second electrode (14),
the dicing region (100y) including
the silicon carbide layer (10) having the first face (F1) and the second face (F2), wherein
a first maximum distance (d1) from the second face (F2) to the first face (F1) of the device region (100x) in a normal direction of the second face (F2)
is greater than a second maximum distance (d2) from the second face (F2) to the first face (F1) of the dicing region (100y) in the normal direction.

2. The semiconductor device (100,110,200,300) according to claim 1, wherein a difference between the first maximum distance (d1) and the second maximum distance (d2) is equal to or more than 0.5 um.

3. The semiconductor device (100,110,200,300) according to claim 1 or 2, wherein
the silicon carbide layer (10) in the device region (100x) includes a first silicon carbide region (24a) of a first conductive type and a second silicon carbide region (24b) provided on the first silicon carbide region (24a), the second silicon carbide region (24b) having a first-conductive-type impurity concentration different from a first-conductive-type impurity concentration of the first silicon carbide region (24a), and
the first silicon carbide region (24a) is in contact with the first face (F1) of the dicing region (100y).

4. The semiconductor device (100,110,200,300) according to claim 3, wherein the second silicon carbide region (24b) is an epitaxial growth layer formed on the first silicon carbide region (24a).

5. The semiconductor device (110) according to any one of claims 1 to 4, wherein
the device region (110x) includes a first region (110x1) and a second region (110x2) surrounding the first region(110x1) and provided along the dicing region (100y), and
a maximum distance (d1y) from the second face (F2) to the first face (F1) of the second region (110x2) in the normal direction is
greater than a maximum distance (d1x) from the second face (F2) to the first face (F1) of the first region (110x1) in the normal direction.

6. The semiconductor device (200) according to any one of claims 1 to 5, wherein
the device region (110x) further includes an insulating layer (20) provided on the first electrode (12), and
at least a portion of an outermost surface of the dicing region (100y) on a side of the first face (F1) is the silicon carbide layer (10).

7. A method for manufacturing a semiconductor device (100,110,200,300), the method comprising:
forming a mask material (54) on a silicon carbide substrate (50) having an expected device region (50x) and an expected dicing region (50y) surrounding the expected device region (50x) and including a first silicon carbide layer (52);
removing the mask material (54) in the expected device region (50x); and
forming a second silicon carbide layer (55) on the first silicon carbide layer (52) in the expected device region (50x) by an epitaxial growth method.

8. The method for manufacturing the semiconductor device (100,110,200,300) according to claim 7, further comprising:
forming a recess or a protrusion on a surface of the first silicon carbide layer (52) in the expected dicing region (50y) before the forming the mask material (54); and
covering the recess or the protrusion in the forming the mask material (54).

9. The method for manufacturing the semiconductor device (100,110,200,300) according to claim 8, wherein the recess or the protrusion is an alignment mark (42).

10. The method for manufacturing the semiconductor device (100,110,200,300) according to any one of claims 7 to 9, further comprising:
forming an electrode (12) on the second silicon carbide layer (55);
forming an insulating layer (20) on the electrode (12); and
removing the insulating layer (20) in the expected dicing region (50y) and exposing the first silicon carbide layer (52).

11. A method for manufacturing a semiconductor device (100,200,300), the method comprising:
forming a second silicon carbide layer (55) on a silicon carbide substrate (50) by using an epitaxial growth method, the silicon carbide substrate (50) having an expected device region (50x) and an expected dicing region (50y) surrounding the expected device region and including a first silicon carbide layer (52);
forming a mask material (66) covering the expected device region (50x); and
removing the second silicon carbide layer (55)on the expected dicing region (50y) using the mask material (66) as a mask to expose the first silicon carbide layer (52).
